# EUROPÄISCHE PATENTSCHRIFT

(11) **EP 1 680 818 B1**
(45) Veröffentlichungstag und Bekanntmachung des Hinweises auf die Patenterteilung: **21.05.2014**
(21) Anmeldenummer: 04818383.4
(22) Anmeldetag: 03.11.2004
(51) Int. Cl.: H01L 33/64, H05K 1/02, H05K 1/18

(54) **Leuchtdioden-Anordnung mit Wärmeabführender Platine**
Light-emitting diode arrangement comprising a heat-dissipating plate
Ensemble diode électroluminescente comprenant une platine dissipant la chaleur

(30) Priorität: 07.11.2003 DE 10351934
(43) Veröffentlichungstag der Anmeldung: 19.07.2006
(73) Patentinhaber: Tridonic Jennersdorf GmbH, 8380 Jennersdorf (AT)
(72) Erfinder: TASCH, Stefan, A-8380 Jennersdorf (AT); HOSCHOPF, Hans, A-8380 Jennersdorf (AT)
(74) Vertreter: Rupp, Christian
(86) Internationale Anmeldenummer: PCT/EP2004/012438
(87) Internationale Veröffentlichungsnummer: WO 2005/048358

(56) Entgegenhaltungen:
- EP-A- 0 755 074
- EP-A- 1 139 019
- WO-A-00/55685
- WO-A-02/089221
- WO-A-03/019679
- US-A- 5 003 357
- US-A- 5 529 852
- US-A1- 2003 189 830
- US-B1- 6 335 548
- US-B1- 6 402 347
- US-B1- 6 498 355

## Beschreibung

Die vorliegende Erfindung bezieht sich auf Leuchtdioden-Anordnungen, bei denen LED-Dice (Leuchtdioden-Chips) auf einer wärmeabführenden Platine angeordnet sind.

Um Anwendungen mit LEDs mit hoher Helligkeit zu realisieren, werden in letzter Zeit immer mehr Hochleistungs-LEDs mit einer Betriebsleistung von mehr als 1 Watt (elektrisch) eingesetzt. Die Chipfläche dieser LED-Dice liegt derzeit im Bereich von 1mm2. Es ist zu erwarten, dass sich in der Zukunft die Betriebsleistung pro LED weiter erhöhen wird, was einerseits durch größere Halbleiter und andererseits durch höhere Stromdichten erreicht wird. Speziell die Erhöhung der Stromdichten bewirkt, dass die Leistungsdichten von LEDs in der nächsten Zeit von derzeit maximal 1 bis 2 Watt_{elektrisch}/mm2 auf über 4 Watt_{elektrisch}/mm2 ansteigen können.

Bei Erhöhung der Leistungsdichten ist indessen gleichzeitig dafür zu sorgen, dass die entsprechend ebenfalls erhöhte Verlustwärme abgeführt wird, um sicherzustellen, dass die Verlustwärme ausreichend vom Halbleiter abgeführt wird.

Eine zu große Erwärmung der LEDs während des Betriebs führt nämlich u.U. zu einer Bauteilzerstörung. Aus diesem Grund muss während des Betriebs der LED gewährleistet sein, dass die Temperatur an der Sperrschicht des p-n Obergangs in der LED beilspielsweise 125°C nicht übersteigt. Diese Gefahr besteht genauer gesagt darin, dass nur ein Teil der von der LED aufgenommenen elektrischen Leistung in Leicht umgesetzt wird, während der andere Teil in Wärme umgewandelt wird (derzeit ist der Licht-Wirkungsgrad von LEDs noch unter 10%). Die Betriebsparameter von LEDs sind daher in Abhängigkeit von der Art der Montage (Assemblierung), der Einbau- und Umgebungsbedingungen derart zu wählen, dass die Sperrschichttemperatur der LED bspw. 125°C nicht übersteigt.

Die Erfindung setzt dahingehend an, dass die Verlustwärme durch Verbesserung des thermischen Widerstands der Anordnung effizienter abgeführt werden kann. Wenn gemäß der Erfindung die Wärme gut durch geringen thermischen Widerstand abgeführt werden kann, kann diese ohne hohe Temperaturgefälle auf den LED-Träger übertragen werden. Der thermische Widerstand wird dabei in K(Kelvin) /W(Watt) ausgedrückt.

Gemäß dem Stand der Technik sind Anordnungen für Hochleistungs-LEDs bekannt, die typischerweise einem thermischen Widerstand von mehr als 15 K/W in dem Bereich von der Sperrschicht zum LED-Träger (Platine oder dgl.) aufweisen. Dies bedeutet, dass gemäß dem Stand der Technik der Temperaturunterschied zwischen dem LED-Träger und der aktiven Zone (Sperrschicht) der LED bei einem Betrieb mit fünf W_{elektrisch} bis zu 75 Kelvin betragen würde. Ausgehend von der genannten maximal zulässigen Sperrschichttemperatur in Dauerbetrieb bedeutet dies, dass bei einer Umgebungstemperatur von beilspielsweise 40°C der Temperaturabfall über einen Wärmetauscher (Kühlkörper) maximal 10°C betragen darf. Dies würde wiederum eine Kühloberfläche von 350 cm2 erfordern, was ganz offensichtlich Probleme mit sich bringt. Darüber hinaus wäre ein Einsatz bei Temperaturen über 50°C nahezu unmöglich, was die Verwendung der LED für bestimmte technische Anwendungen, wie beispielsweise im Kfz-Bereich unmöglich machen würde.

Aus dem Stand der Technik ist es bekannt, als LED-Träger gedruckte Leiterplatten (printed circuit boards, PCBs) zu verwenden. Üblicherweise weisen diese ein organisches Epoxidharz auf, das thermisch nur sehr schlecht leitet und daher die thermische Ableitung der Verlustwärme von der LED auf den Träger erschwert.

Alternativ sind auch Keramikplatinen bekannt, die zwar bessere thermische Eigenschaften im Vergleich zu den Leiterplatten auf Epoxidharzbasis aufweisen, dagegen aber sehr spröde und brüchig sind, was ihre Verwendung als Trägermaterial mehr als einschränkt.

In technischen Hochleistungsanwendungen werden gemäß dem Stand der Technik auch Metallkernplatinen eingesetzt. Diese haben typischerweise einen sandwichartigen Aufbau basierend aus der Metallkernbasis, einer Isolationsschicht und einer Leiterbahn.

US 6,498,355 B1 beschreibt eine Leuchtdioden-Anordnung, aufweisend einen Leuchtdioden-Chip und eine Mehrschicht-Platine aus Metall. Die Basis ist ein Kern der Platine und dient zur Wärmeabfuhr. Ferner weist die Leuchtdioden-Anordnung eine elektrisch isolierende und thermisch leitende Verbindungsschicht zwischen einer Emissionsfläche des Leuchtdioden-Chips und der Platine auf. Dabei ist zwischen dem Leuchtdioden-Chip und der Platine ein Zwischenträger angeordnet.

Angesichts dieses Standes der Technik ist es Aufgabe der vorliegenden Erfindung, eine Montage-Anordnung für Leuchtdioden mit verbesserter Wärmeabfuhr vorzuschlagen.

Die Erfindung geht dabei von der Erkenntnis aus, dass nach Stand der Technik bei der Verwendung von Metallkernplatinen die Abfuhr der Verlustwärme von der LED, welche auf die Leiterbahn aufgesetzt ist, durch die darunterliegende Isolationsschicht eingeschränkt ist, was wiederum die Leistungsdichte der LED eingrenzt.

Die angeführte Aufgabe wird erfindungsgemäß durch die Merkmale der unabhängigen Ansprüche gelöst. Die abhängigen Ansprüche bilden den zentralen Gedanken der Erfindung in besonders vorteilhafter Weise weiter.

Gemäß der Erfindung ist also eine Leuchtdioden-Anordnung mit wenigstens einem Leuchtdioden-Chip (LED-Die) vorgesehen. Weiterhin ist eine Mehrschichtplatine aufweisend eine Basis aus einem thermisch gut leitfähigen Material, wie beispielsweise Metall vorgesehen, wobei die Basis ein Kern der Platine ist und zur Wärmeabfuhr dient und wobei eine elektrisch isolierende und thermisch leitende Verbindungsschicht zwischen der Emissionsfläche des Leuchtdioden-Chips und der Platine angeordnet ist. Der Leuchtdioden-Chip ist derart angeordnet" dass das Substrat der Leuchtdioden von der Platine abgewandt ist, wobei zwischen dem Leuchtdioden-Chip und der Basis der Platine ein zu diesen Teilen separater Zwischenträger angeordnet ist, mit dem der Leuchtdioden-Chip elektrisch kontaktiert ist, wobei der Zwischenträger durch ein Aluminiumnitrid-Substrat gebildet ist, wobei die elektrisch isolierende Verbindungsschicht eine Klebefolie ist, welche direkt auf der Basis angeordnet ist und auf welcher direkt der Zwischenträger angeordnet ist. Da im Gegensatz zum Stand der Technik die thermisch isolierende (Epoxid-) Schicht in Wegfall gelangt, wird der Wärmeübertrag von dem Leuchtdioden-Chip zu dem wärmeabführenden Basismaterial der Platine hin deutlich verbessert.

Eine isolierende Klebeschicht, die durch eine Klebefolie realisiert ist, ist insbesondere dann von Vorteil, wenn ein Leuchtdioden-Chip verwendet wird, dessen der Basis zugewandte Oberfläche elektrisch leitend ist. In diesem Fall muss eine gesonderte elektrische Isolierung zwischen dem Chip und der Basis erfolgen, um Kurzschlüsse und ESD-Ausfälle zu vermeiden.

Der Leuchtdioden-Chip kann in einer Vertiefung der Platine untergebracht sein. Dabei kann der Leuchtdioden-Chip derart versenkt sein, dass seine Oberseite nicht über die Kontur der Platine übersteht und beispielsweise plan mit der Oberseite der Platine abschließt.

Die Vertiefung, in die der LED-Chip gesetzt ist, kann dabei in der wärmeabführenden Basis der Platine ausgebildet sein.

Gleichzeitig kann die Vertiefung weitere Funktionen aufweisen. Beispielsweise kann die Vertiefung eine Reflektorwirkung haben, wobei vorteilhafterweise die Wände der Vertiefung zumindest teilweise abgeschrägt sind.

Insbesondere ist die Leuchtdioden-Anordnung durch die "Face Down"-Montagetechnik gebildet, bei der der Leuchtdioden-Chip derart angeordnet ist, dass das Substrat der Leuchtdioden von der Platine abgewandt ist.

Der Leuchtdioden-Chip kann mittels eines Leitklebers auf dem Zwischenträger angeordnet sein.

Die der Platine zugewandte Seite des Zwischenträgers kann elektrisch isolierend sein, wobei der dem Leuchtdioden-Chip zugewandte Bereich des Zwischenträgers leitende Bereiche wie beispielsweise Leiterbahnen aufweisen kann.

Wenigstens der Bereich des wenigstens einen Leuchtdioden-Chips kann von einer Linse wie beispielsweise einer Fresnel-Linse überdeckt sein.

Der Bereich zwischen der Platine und der Linse kann wenigstens teilweise mit einem Farbkonversionsstoff gefüllt sein. Der Farbkonversionsstoff kann also neben und/oder über dem Leuchtdioden-Chip angeordnet sein. Gegebenenfalls kann auch die Vertiefung seitlich vom Chip mit einem Farbkonversionsstoff aufgefüllt sein, um eine LED mit wesentlich weißer Lichtcharakteristik zu erhalten.

Der Leuchtdioden-Chip kann mittels Drähten von einer Leiterplatte aus kontaktiert sein, wobei diese Leiterplatte seitlich von dem Leuchtdioden-Chip sandwichartig mittels einer dazwischenliegenden Isolierschicht auf der Platine aufgebracht ist.

Weitere Merkmale, Vorteile und Eigenschaften der vorliegenden Erfindung sollen nunmehr unter Bezugnahme auf die Figuren der begleitenden Zeichnungen erläutert werden.
- Figur 1 zeigt ein Beispiel einer LED-Anordnung,
- Figur 2 zeigt eine Abwandlung von Figur 1 dahingehend, dass in dem Metall-Basismaterial eine Vertiefung vorgesehen ist, in der der LED-Die eingesetzt ist,
- Figur 3 zeigt eine Abwandlung von Figur 2 dahingehend, dass die Vertiefung des Trägers insgesamt mit einem Farbkonversionsstoff aufgefüllt ist,
- Figur 4 zeigt, wie eine LED-Anordnung mit mehreren LED-Dice von einer flachbauenden Fresnel-Linse abgedeckt sein kann,
- Figur 5 zeigt ein erfindungsgemäßes Ausführungsbeispiel, bei dem der LED-Die "Face Down" montiert ist, und
- Figur 6 zeigt ein weiteres erfindungsgemäßes Ausführungsbeispiel, bei dem der LED-Die "Face Down" montiert ist.

Wie oben bereits ausgeführt, soll gemäß der vorliegenden Erfindung ein LED-Die möglichst direkt auf die wärmeableitende Basis beispielsweise einer Metallkernplatine aufgesetzt sein. Bei diesem Schritt muss indessen das Problem überwunden werden, dass LED-Dies häufig über das LED-Substrat bzw. über ihre der Basis zugewandte Oberfläche leitfähig sind, wodurch sich bei einer derartigen Anordnung ein Kurzschluss zum Leiterplattenbasismaterial ergeben kann, der oft unerwünscht ist und besonders hinsichtlich der Verschaltungsmöglichkeiten der LEDs keinerlei Designfreiheit lässt.

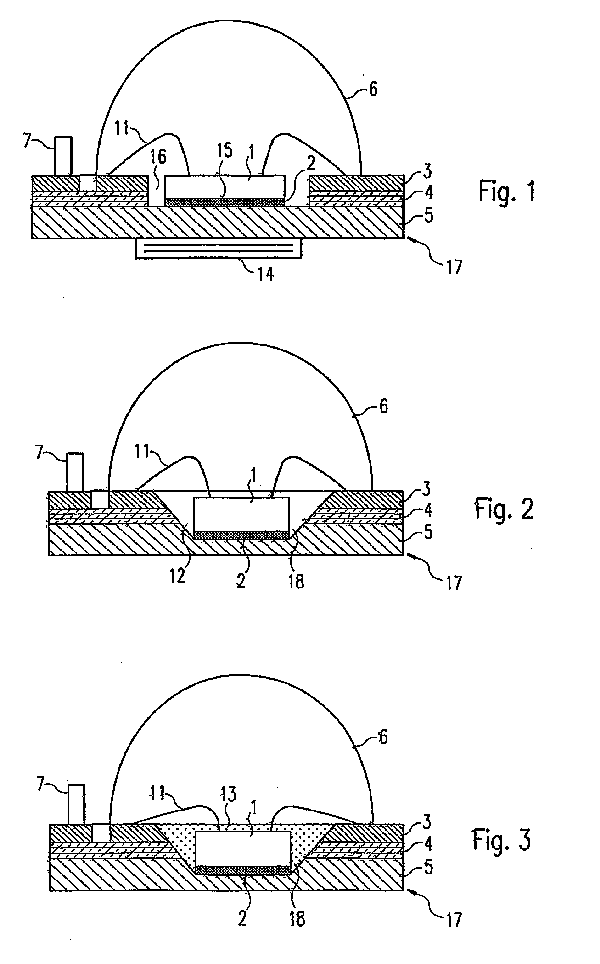

Wie aus dem Beispiel der Figur 1 ersichtlich ist daher ein LED-Die mittels einer thermisch leitfähigen, aber elektrisch isolierenden Schicht 2 auf das Basismaterial (beispielsweise Metall) 5 einer Metallkernplatine 17 gesetzt.

Die Metallkernplatine 17 weist neben diesem Basis-Metallkern 5 eine darüberliegende elektrisch isolierende Schicht 4 sowie eine elektrisch leitfähige Schicht mit Leiterbahnen 3 auf, wobei vorzugsweise die elektrisch isolierende Schicht 4 und die Leiterbahnen-Schicht 3 deckungsgleiche Ausnehmungen 16 aufweisen, in die der LED-Die 1 eingesetzt ist.

Die elektrische Kontaktierung des LED-Dies erfolgt bei dieser Anordnung, bei der das Substrat des LED-Dies der Platine 1) zugewandt ist, seitlich von den Leiterbahnen 3 mittels Drähten 11 auf die Oberseite des LED-Dice 1.

Auf der Unterseite des Basismaterials 5 der Metallkernplatine 7 können weitere Kühlkörper 14 bekannter Art angeordnet sein.

Insbesondere der Bereich des LED-Dies 1 und der Ausnehmung 16 kann von einer im Wesentlichen kalottenförmigen Linse 6 überdeckt sein, die das vom dem LED-Die 1 abgestrahlte Licht bündelt.

Die elektrische Kontaktierung der in Figur 1 dargestellten LED-Anordnung kann über außerhalb des von der Linse 6 überdeckten Bereichs vorgesehene Steckkontakte 7 etc. erfolgen.

Als Basismaterial 5 der Platine 17 wird allgemein ein Material mit hoher thermischer Leitfähigkeit eingesetzt, so dass bevorzugt Metalle, wie beispielsweise Aluminium oder Kupfer zur Verwendung kommen können.

Die elektrisch isolierende aber thermisch leitfähige Verbindungsschicht 2 kann zum Beispiel eine nicht leitende Substratschicht der LEDs (für grüne LEDs wird z. B. oftmals Saphir verwendet) oder aber auch ein thermisch leitfähiger und elektrisch isolierender Kleber sein. Die elektrisch isolierende aber thermisch leitfähige Verbindungsschicht 2 kann also Teil des LED-Dies 1, der Mehrschichtplatine 17 und/oder eine davon separate Schicht sein. Die separate Schicht ist insbesondere dann erforderlich, wenn die LED-Dies 1 derart angeordnet sind, dass ihre der Mehrschichtplatine 17 zugewandte Oberfläche elektrisch leitfähig ist. Ferner ist beispielsweise bei roten LEDs, die aus zwei übereinander angeordneten Dioden-Schichten bestehen, immer eine der beiden Schichten der Mehrschichtplatine 17 zugewandt, weshalb zur Vermeidung von Kurzschlüssen und ESD-Ausfällen eine separate Isolierung erforderlich ist.

Die Isolationsschicht 4 der Metallkernplatine 17 kann beispielsweise aus organischen Materialien oder dünnen Keramiken bestehen (letztere sind z. B. auf den Metallträger 5 aufgeschlämmt, bzw. der Metallträger wird mit einem eingebrannten Keramiktape beschichtet.

In dem Beispiel von Figur 2 weist die Basis 5 der Platine 17 ebenfalls eine Vertiefung 18 auf, in die der LED-Die 1 eingesetzt ist. Da die Wände dieser Vertiefung 18 in dem metallischen Basismaterial 5 der Platine 17 abgeschrägt sind, können diese metallischen Wände der Vertiefung 18 eine vorteilhafte Spiegel-bzw. Reflektorwirkung entfalten. Im übrigen ist auch eine andere Formgebung der Wände und/oder des Bodens der Vertiefung denkbar, die Spiegel-oder Reflektorwirkung aufweist.

Somit dient das Basismaterial 5 der Mehrschichtplatine 17 nicht nur zur Befestigung und Wärmeabfuhr des LED-Dies 1, sondern auch zur gezielten Lichtlenkung in Richtung weg von der Platine. Diese Lichtlenkung durch die Reflektorwirkung der Vertiefung 18 im Basismaterial 5 der Platine 17 ist vorzugsweise mit der Wirkung der Linse 6 abgestimmt.

Es ist aus dem Stand der Technik bekannt, dass mittels Farbkonversionsmitteln "weiße LEDs" erreicht werden können. Derartige LEDs werden in der Fachwelt oft auch als "Phosphorkonverter-LEDs" oder "Lumineszenzkonversions-LEDs" bezeichnet. Wie aus Figur 3 ersichtlich, kann ein derartiger Farbkonversionsstoff 13 direkt auf die LED aufgebracht sein, in den Zwischenraum zwischen Linse 6 und LED-Die 1 eingefüllt sein oder aber gemäß dem in Figur 3 dargestellten Beispiel die Vertiefungen 12, 18 auffüllend angeordnet sein, sodass der Füllstoff die Oberseite der Leiterbahnschicht 3 der Platine 17 bündig abschließt.

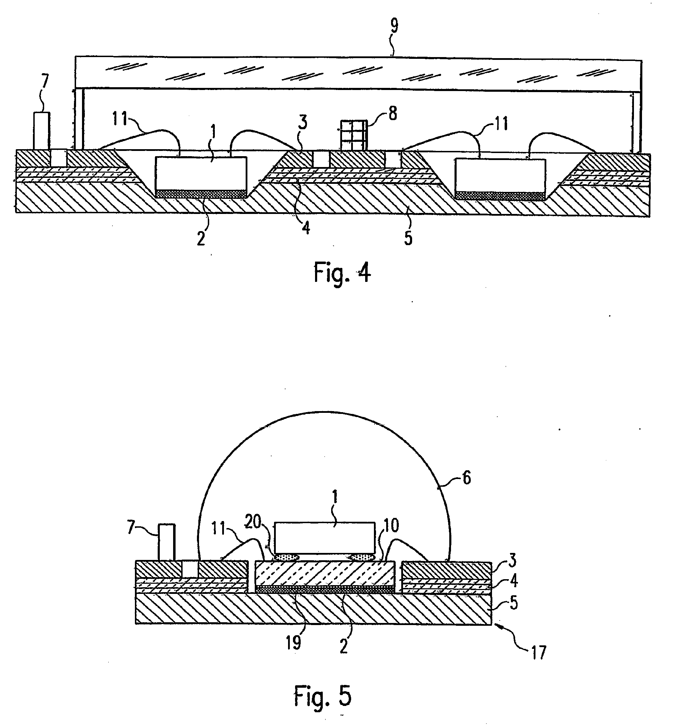

Bei dem Beispiel von Figur 4 ist die kalottenförmige Linse durch eine flachbauende Fresnel-Linse 9 ersetzt. Gleichzeitig ist aus Figur 4 ersichtlich, dass eine derartige Linse mehrere LED-Dies 1 überdecken kann. In dem Bereich zwischen zwei LEDs und unterhalb der Fresnel-Linse 9 kann eine Ansteuerelektronik 8 für die LEDs (Konstantstromquelle etc.) vorgesehen sein.

Die Beispiele von Figur 1 bis Figur 4 zeigen sämtlich LED-Dies, die "Face Up", das heißt mit dem LED-Substrat nach unten (in Richtung des Basismaterials 5 der Platine 17) angeordnet sind.

Figur 5 zeigt nunmehr den erfindungsgemäßen umgekehrten Fall, das heißt gemäß Figur 5 ist der LED-Die 1 "Face Down" angeordnet, so dass das Substrat der LEDs von dem Metallkern 5 der Platine 17 wegweist. In diesem Fall ist der LED-Die 1 mittels eines Leitklebers 20 auf einen Zwischenträger 10 angeordnet. Der Leitkleber 20 weist beispielsweise eine Dicke von weniger als 10 µm und eine thermische Leitfähigkeit von mehr als 2 W/mK auf. Die elektrische Kontaktierung des LED-Dice 1 von Figur 5 erfolgt somit über Drähte 11, die mit dem Zwischenträger 10 kontaktiert sind. Derartig "Face Down" zumontierte LED-Dies weisen üblicherweise im Vergleich zu "Face Up" montierten LED-Dies höhere Wirkungsgrade auf.

Der Zwischenträger 10 ist beispielsweise aus einem Keramikmaterial und weist auf seiner Oberseite Leiterbahnen auf, während die Unterseite gegebenenfalls durch eine weitere Isolationsschicht 19 gegenüber dem Metallkern 5 der Platine 17 elektrisch isoliert ist. Wiederum ist indessen auch die Isolierschicht 19 so ausgestattet, dass sie thermisch gut leitfähig ist.

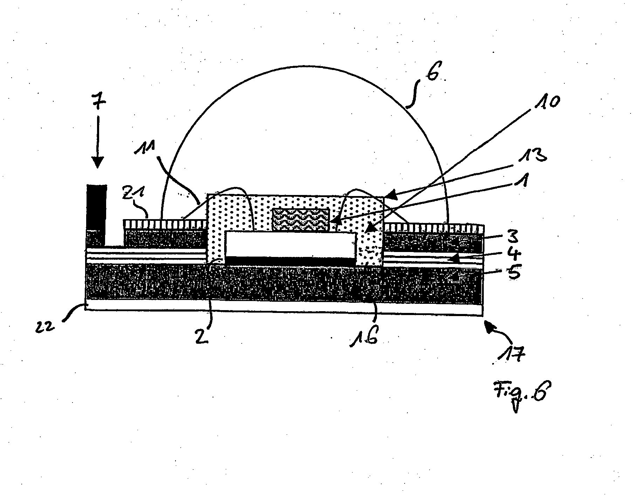

Abschließend ist in Figur 6 ein weiteres erfindungsgemäßes Ausführungsbeispieldargestellt, bei dem der LED-Die 1 wiederum "Face Down" auf einem Zwischenträger 10 angeordnet ist, um die bei dieser Anordnung verbesserte Lichtabgabe und damit höhere Helligkeit zu erzielen. Bei diesem Zwischenträger handelt es sich vorzugsweise um ein AlN-(Aluminiumnitrid)-Keramikträgersubstrat, welches hervorragende wärmeleitende Eigenschaften aufweist und gleichzeitig elektrisch isolierend wirkt. Der Vorteil in der Verwendung dieses zusätzlichen Zwischenträgers 10 besteht darin, dass eine höhere ESD-(electro static discharge) -Festigkeit erreicht wird und die Metkallkernplatine elektrisch neutral bleibt.

Ergänzend zu der Ausführungsform in Figur 5 ist der LED-Die 1 nunmehr mit einem Farbkonversionsstoff 13 umgeben, um das Licht in eine gewünschte (Misch-) Farbe umzuwandeln. Die Oberseite der elektrisch leitfähigen Schicht 3 ist ferner mit einer zusätzlichen Klebeschicht 21 überdeckt, deren Aufgabe es ist, die Linse 6 zu fixieren. Schließlich ist im dargestellten Ausführungsbeispiel an der Unterseite der Platine 17 noch ein doppelseitiges Klebeband 22 vorgesehen, welches eine einfache Befestigung der gesamten Leuchtdioden-Anordnung ermöglicht.

## Patentansprüche

1. Leuchtdioden-Anordnung, aufweisend:
- wenigstens einen Leuchtdioden-Chip (1),
- eine Mehrschicht-Platine (17) mit einer Basis (5) aus einem thermisch gut leitfähigen Material, insbesondere aus Metall, wobei die Basis (5) ein Kern der Platine (17) ist und zur Wärmeabfuhr dient, und
- eine elektrisch isolierende und thermisch leitende Verbindungsschicht (2) zwischen der Emissionsfläche des Leuchtdioden-Chips (1) und der Platine,
wobei der Leuchtdioden-Chip (1) derart angeordnet ist, dass das Substrat der Leuchtdioden von der Platine (17) abgewandt ist,
wobei zwischen dem Leuchtdioden-Chip (1) und der Basis (5) der Platine (17) ein zu diesen Teilen separater
Zwischenträger (10) angeordnet ist, mit dem der Leuchtdioden-Chip (1) elektrisch kontaktiert ist, **dadurch gekennzeichnet, dass** der Zwischenträger (10) durch ein Aluminiumnitrid-Substrat gebildet ist, und
die elektrisch isolierende Verbindungsschicht (2) eine Klebefolie ist, welche direkt auf der Basis (5) angeordnet ist und auf welcher direkt der Zwischenträger (10) angeordnet ist.

2. Anordnung nach einem der vorhergehenden Ansprüche,
**dadurch gekennzeichnet,**
**dass** der Leuchtdioden-Chip (1) in einer Vertiefung (16) der Platine (17) untergebracht ist.

3. Anordnung nach einem der vorhergehenden Ansprüche,
**dadurch gekennzeichnet,**
**dass** der Leuchtdioden-Chip (1) im Bereich einer Vertiefung (12) in dem Basismaterial (5) der Platine (17) angeordnet ist.

4. Anordnung nach Anspruch 2 oder 3,
**dadurch gekennzeichnet,**
**dass** der Leuchtdioden-Chip (1) nicht über die Kontur der Platine (5) übersteht.

5. Anordnung nach einem der Ansprüche 2 bis 4,
**dadurch gekennzeichnet,**
**dass** der Leuchtdioden-Chip (1) plan mit der Oberseite der Platine (17) abschließt.

6. Anordnung nach einem der Anspruch 2 bis 4,
**dadurch gekennzeichnet,**
**dass** die Vertiefung (12, 16) die Funktion eines Reflektors hat.

7. Anordnung nach einem der Ansprüche 2 bis 6,
**dadurch gekennzeichnet,**
**dass** die Wände der Vertiefung (12, 16) zumindest teilweise abgeschrägt sind.

8. Anordnung nach einem der vorhergehenden Ansprüche,
**dadurch gekennzeichnet,**
**dass** der Leuchtdioden-Chip (1) mittels eines Leitklebers (20) auf dem Zwischenträger (10) angeordnet ist.

9. Anordnung nach einem der vorhergehenden Ansprüche,
**dadurch gekennzeichnet,**
**dass** die der Platine (17) zugewandte Seite des Zwischenträgers (10) elektrisch isolierend ist.

10. Anordnung nach Anspruch 9,
**dadurch gekennzeichnet,**
**dass** der dem Leuchtdioden-Chip (1) zugewandte Bereich des Zwischenträgers (10) leitende Bereiche aufweist.

11. Anordnung nach einem der vorhergehenden Ansprüche,
**dadurch gekennzeichnet,**
**dass** wenigstens der Bereich des Leuchtdioden-Chips (1) von einer Linse (6), insbesondere einer Fresnel-Linse (9) überdeckt ist.

12. Anordnung nach Anspruch 11,
**dadurch gekennzeichnet,**
**dass** der Bereich zwischen der Platine (17) und der Linse (6, 9) wenigstens teilweise mit einem Farbkonversionsstoff (13) gefüllt ist.

13. Anordnung nach Anspruch 12,
**dadurch gekennzeichnet,**
**dass** der Farbkonversionsstoff (13) über und neben dem Leuchtdioden-Chip (1) angeordnet ist.

14. Anordnung nach einem der vorhergehenden Ansprüche,
**dadurch gekennzeichnet,**
**dass** der Leuchtdioden-Chip (1) mittels Drähten (11) von einer Leiterplatte (3) aus kontaktiert ist, die sandwichartig mittels einer dazwischenliegenden Isolierschicht (4) auf der Platine (17) angebracht ist.

## Claims

1. Light-emitting diode arrangement, comprising:
- at least one light-emitting diode chip (1),
- a multilayered plate (17) having a base (5) consisting of a material with good thermal conductivity, in particular of metal, wherein the base (5) is a core of the plate (17) and is used for heat dissipation, and
- an electrically insulating and thermally conductive connecting layer (2) between the emission area of the light-emitting diode chip (1) and the plate,
wherein the light-emitting diode chip (1) is arranged in such a way that the substrate of the light-emitting diodes faces away from the plate (17),
wherein arranged between the light-emitting diode chip (1) and the base (5) of the plate (17) is an intermediate carrier (10) which is separate from said parts and is used to make electrical contact with the light-emitting diode chip (1),
**characterized in that**
the intermediate carrier (10) is formed by an aluminium nitride substrate, and
the electrically insulating connecting layer (2) is an adhesive film, which is arranged directly on the base (5) and on which the intermediate carrier (10) is arranged directly.

2. Arrangement according to one of the preceding claims, **characterized in that** the light-emitting diode chip (1) is accommodated in a depression (16) in the plate (17).

3. Arrangement according to one of the preceding claims, **characterized in that** the light-emitting diode chip (1) is arranged in the region of a depression (12) in the base material (5) of the plate (17).

4. Arrangement according to Claim 2 or 3, **characterized in that** the light-emitting diode chip (1) does not protrude beyond the contour of the plate (5).

5. Arrangement according to one of Claims 2 to 4, **characterized in that** the light-emitting diode chip (1) terminates level with the upper side of the plate (17).

6. Arrangement according to one of Claims 2 to 4, **characterized in that** the depression (12, 16) has the function of a reflector.

7. Arrangement according to one of Claims 2 to 6, **characterized in that** the walls of the depression (12, 16) are at least partially bevelled.

8. Arrangement according to one of the preceding claims, **characterized in that** the light-emitting diode chip (1) is arranged on the intermediate carrier (10) by means of a conductive adhesive (20).

9. Arrangement according to one of the preceding claims, **characterized in that** that side of the intermediate carrier (10) which faces the plate (17) is electrically insulating.

10. Arrangement according to Claim 9, **characterized in that** that region of the intermediate carrier (10) which faces the light-emitting diode chip (1) has conductive regions.

11. Arrangement according to one of the preceding claims, **characterized in that** at least the region of the light-emitting diode chip (1) is covered by a lens (6), in particular a Fresnel lens (9).

12. Arrangement according to Claim 11, **characterized in that** that region between the plate (17) and the lens (6, 9) is filled at least partially with a colour conversion material (13).

13. Arrangement according to Claim 12, **characterized in that** the colour conversion material (13) is arranged over and next to the light-emitting diode chip (1).

14. Arrangement according to one of the preceding claims, **characterized in that** contact is made with the light-emitting diode chip (1) by means of wires (11) from a printed circuit board (3), which is fitted on the plate (17) in the manner of a sandwich by means of an interposed insulating layer (4).

## Revendications

1. Ensemble diode électroluminescente, présentant :
- au moins une puce de diode électroluminescente (1),
- une platine multicouche (17) avec une base (5) en un matériau bon conducteur de chaleur, en particulier en métal, dans lequel la base (5) est un noyau de la platine (17) et sert à la dissipation de chaleur, et
- une couche de liaison (2), électriquement isolante et thermiquement conductrice, entre la surface d'émission de la puce de diode électroluminescente (1) et la platine, dans lequel la puce de diode électroluminescente (1) est disposée de telle sorte que le substrat des diodes électroluminescentes est opposé à la platine (17),
dans lequel un support intermédiaire (10) est disposé entre la puce de diode électroluminescente (1) et la base (5) de la platine (17), le support intermédiaire (10) étant distinct de ces parties et la puce de diode électroluminescente (1) étant en contact électrique avec le support intermédiaire (10),
**caractérisé en ce que**
le support intermédiaire (10) est constitué par un substrat de nitrure d'aluminium, et la couche de liaison (2) électriquement isolée est un film adhésif, qui est disposé directement sur la base (5) et sur lequel le support intermédiaire (10) est directement disposé.

2. Ensemble selon l'une des revendications précédentes,
dans lequel
la puce de diode électroluminescente (1) est logée dans un creux (16) de la platine (17).

3. Ensemble selon l'une des revendications précédentes,
**caractérisé en ce que**
la puce de diode électroluminescente (1) est disposée dans la région d'un creux (12) dans le matériau de base (5) de la platine (17).

4. Ensemble selon la revendication 2 ou 3,
**caractérisé en ce que**
la puce de diode électroluminescente (1) ne fait pas saillie au-delà du contour de la platine (5).

5. Ensemble selon l'une des revendications 2 à 4,
**caractérisé en ce que**
la puce de diode électroluminescente (1) se termine de manière plane de niveau avec le côté supérieur de la platine (17).

6. Ensemble selon l'une des revendications 2 à 4,
**caractérisé en ce que**
le creux (12, 16) a la fonction d'un réflecteur.

7. Ensemble selon l'une des revendications 2 à 6,
**caractérisé en ce que**
les parois du creux (12, 16) sont au moins partiellement chanfreinées.

8. Ensemble selon l'une des revendications précédentes,
**caractérisé en ce que**
la puce de diode électroluminescente (1) est agencée sur le support intermédiaire (10) au moyen d'une colle conductrice (20).

9. Ensemble selon l'une des revendications précédentes,
**caractérisé en ce que**
le côté du support intermédiaire (10) faisant face à la platine (17) est isolé électriquement.

10. Ensemble selon la revendication 9,
**caractérisé en ce que**
la région du support intermédiaire (10) faisant face à la puce de diode électroluminescente (1) présente des régions conductrices.

11. Ensemble selon l'une des revendications précédentes,
**caractérisé en ce que**
au moins la région de la puce de diode électroluminescente (1) est recouverte par une lentille (6), en particulier une lentille de Fresnel (9).

12. Ensemble selon la revendication 11,
**caractérisé en ce que**
la région entre la platine (17) et la lentille (6, 9) est remplie au moins en partie avec une substance de conversion de couleur (13).

13. Ensemble selon la revendication 12,
**caractérisé en ce que**
la substance de conversion de couleur (13) est disposée au-dessus et à côté de la puce de diode électroluminescente (1).

14. Ensemble selon l'une des revendications précédentes,
**caractérisé en ce que**
la puce de diode électroluminescente (1) est mise en contact au moyen de fils (11) à partir d'un circuit imprimé (3), lequel est disposé en sandwich sur la platine (17) au moyen d'une couche intermédiaire d'isolation (4).
